# EUROPEAN PATENT SPECIFICATION

(11) **EP 0 212 295 B1**
(45) Date of publication and mention of the grant of the patent: **15.12.1993**
(21) Application number: 86110053.5
(22) Date of filing: 22.07.1986
(51) Int. Cl.: H01L 29/14, H01L 29/76, H01L 29/205

(54) **Monocrystalline semiconductor superlattice structures**
Monolitische Halbleiterübergitterstruktur
Structures semi-conductrices monocristallines à super-réseau

(30) Priority: 13.08.1985 US 765403
(43) Date of publication of application: 04.03.1987
(73) Proprietor: International Business Machines Corporation, Armonk, N.Y. 10504 (US)
(72) Inventor: Chang, Leroy Li-Gong, Goldens Bridge New York, 10526 (US); Esaki, Leo, Katonah New York, 10536 (US)
(74) Representative: Burt, Roger James, Dr.

(56) References cited:
- IBM TECHNICAL DISCLOSURE BULLETIN, vol. 27, no. 4B, September 1984, pages 2592-2593, New York, US; L.L. CHANG et al.: "Edge superlattice Bloch oscillator"
- Idem
- APPLIED PHYSICS LETTERS, vol. 41, no. 7, 1st October 1982, pages 635-638, American Institute of Physics, New York, US; P.M. PETROFF et al.: "Toward quantum well wires: Fabrication and optical properties"
- Idem
- PATENT ABSTRACTS OF JAPAN, vol. 8, no. 70 (E-235)[1507], 3rd April 1984; & JP-A-58 218 174
- Idem
- APPLIED PHYSICS LETTERS, vol. 47, no. 12, 15th December 1985, pages 1324-1326, American Institute of Physics, Woodbury, New York, US; Y.-C. CHANG et al.: "A new one-dimensional quantum well structure"

## Description

The present invention relates to monocrystalline semiconductor superlattice structures, in particular to such structures for defining a carrier path.

The efforts controlling scattering losses have been effective in the structure known as a superlattice, made up of a line of thin epitaxial regions of semiconductors with different properties, wherein the width dimension of regions in the superlattice is reduced to less than the electron mean free path and the carrier transport in certain directions is restricted.

As the art has developed, a variety of engineered structures have exhibited extraordinary transport and optical properties. A goal in semiconductor superlattices is to produce a structure in which the dimensionality of carrier movement is reduced. The development of the superlattice art and a description of the goals that the superlattices are to achieve is described in "Semiconductor Superlattices and Quantum Wells" by Leo Esaki published in the Proceedings of the 17th International Conference on the Physics of Semiconductors, San Francisco, California, August 6-10, 1984, beginning on page 473.

There have been two structures in the art in which an effort has been made to use a superlattice to provide single dimensional carrier movement. Both structures use an inversion layer adjacent an interface for confinement in one direction and a superlattice region thickness for confinement in a second direction leaving freedom of carrier movement in the third direction. The first is in the Japanese Journal of Applied Physics, Vol. 19, No. 12, Dec. 1980, pp. L735-L738 wherein, a V shaped structure gate in a GaAs/GaAlAs superlattice produces an inversion layer in an intermediate region of the superlattice adjacent the gate. The second is in the IBM Technical Disclosure Bulletin Vol. 27, No. 4B, September 1984, p. 2592 in which an inversion layer adjacent an interface across a plurality of superlattice regions provides oscillator performance. This structure does not provide uncoupled quantum wells intersecting with a smaller band gap lower energy level layer.

In accordance with a first aspect of the present invention there is provided a multidirectional monocrystalline semiconductor superlattice structure comprising in combination: a first series of superlattice layers in a first crystallographic direction comprising at least one group of alternate layers having a different energy band gaps and thickness dimensions including a first layer with a first energy band gap which is bounded by second and third layers having energy band gaps and thickness dimensions higher than the first layer; thereby to provide a substantially uncoupled lower energy level for charge carriers in the first layer, at least one second series of superlattice layers, each in a crystallographic direction different from the first direction and intersecting the respective layers of the first series, the second series having a fourth layer immediately adjacent the edges of the layers of the first series, the fourth layer being narrower than the second and third layers, having an energy band gap lower than the first energy band gap and being bounded by a fifth layer having an energy band gap higher than the first energy band gap; thereby to define a one-dimensional carrier path along the intersections of the first and fourth layers.

Thus there may be provided, a semiconductor device comprising a structure according to the invention and comprising ohmic external electrodes means which are located at separated points along the carrier path and control means are positioned on the control surface in current influencing proximity to the path intermediate said separated points and operable to alter the carrier population in the carrier path, whereby the carrier path defines a one dimensional quantum pipeline path.

According to a second aspect of the present invention there is also provided a process of forming a multidirectional monocrystalline semiconductor superlattice structure comprising in combination the steps of: fabricating a series of different thickness epitaxial semiconductor superlattice layers in a first crystallographic direction; establishing at least one growth plane of growth quality surface texture on the crystal of said first series of layers, said plane being in a crystallographic direction different from said first crystallographic direction; and growing at least one subsequent series of superlattice layers with controlled thickness on each said growth plane wherein in the first series of layers there is formed at least one group of layers comprising a first layer with a first energy band gap and a first thickness which is bounded by second and third layers which are thicker than the first layer and have an energy band gap higher than the first energy band gap, thereby to provide a substantially uncoupled lower energy level for charge carriers in the first layer; wherein, in one subsequent series of layers, a fourth layer is formed immediately adjacent the growth crystal of the first series of layers, the fourth layer being narrower than the second and third layers and having an energy band gap lower than the first energy band gap, and wherein the fourth layer is bounded by a fifth layer having a higher energy band gap than the first layer and a thickness which is controlled to a dimension enabling a control surface of the fifth layer to be in current influencing proximity to the carrier path; thereby to define a one-dimensional carrier path along the intersections of the first and fourth layers.

The confinement principle involved produces a carrier path having either electrons or holes or both.

Control and response to signals is provided by applying to a surface of the superlattice a conductor that is in current influencing proximity to the pipeline.

Applying the invention to transport type devices, such as transistors, can provide increased speed through directionality and through high mobility, and, increased density through ultrafine dimensions. When applied to optical type semiconductor devices such as optical detectors and light emitting devices including lasers a strong optical coupling is achieved due to the large joint density of states and large electron binding energies because both electrons and holes coexist under identical complementary conditions.

While structures according to the invention will hereinafter be described with reference to the drawings, in two dimensions only, for reasons of clarity, it will be apparent to one skilled in the art that many extensions and substitutions are possible in the application thereof in view of the general physical principles involved. In the accompanying drawings:
Figure 1 is a schematic view of a semiconductor superlattice crystal according to the invention illustrating a one-dimensional carrier path;
Figures 2, 3 and 4 are energy diagrams of the crystal of Figure 1 in respectively the Z, the Y and the X directions;
Figure 5 is a schematic view of the energy levels in the structure of Figure 1 in three-dimensions illustrating the confinement provided and the presence of both electrons and holes; and
Figure 6 is an illustration of a control element for bias and gating and device connections to form a quantum pipeline carrier path.

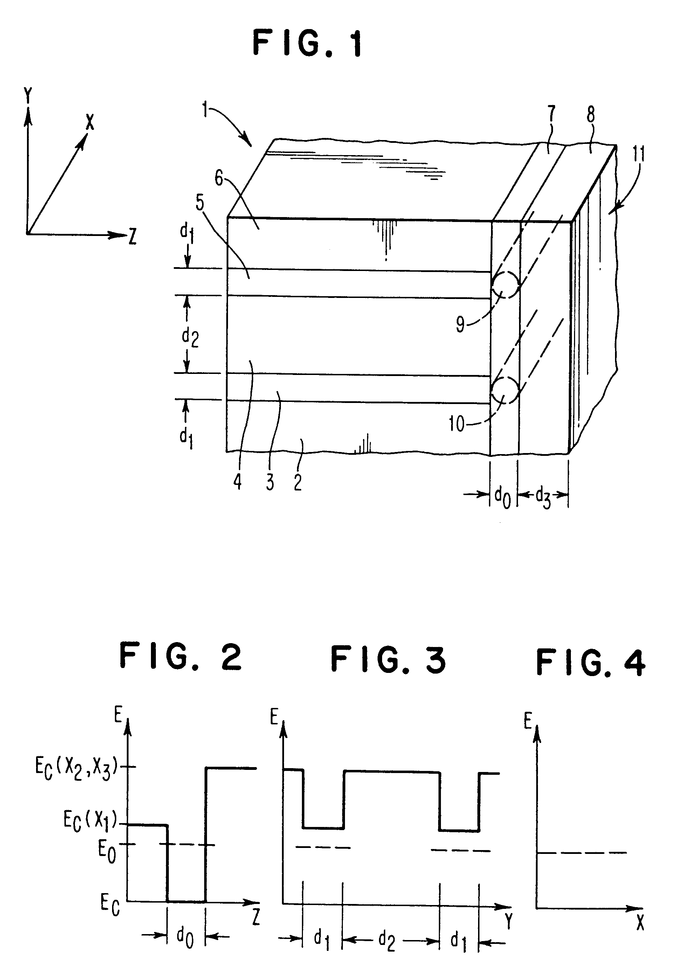

Referring to Figure 1, a schematic view is provided showing a multidirectional superlattice crystal (1) with a control element surface (11), and illustrating a single dimensional carrier path (9).

In the superlattice 1, in one crystallographic direction there are layers of semiconductor material having different energy gaps and dimensions. Five layers are shown to illustrate the principle. The layers having a larger energy gap 2, 4 and 6 also have a larger thickness dimension d₂ and the layers with a smaller energy gap 3 and 5 also have a smaller thickness dimension d₁.

In Figure 1 an orientation figure for the X, Y and Z axes is shown. In the multidirectional superlattice crystal 1 there are layers in the XZ plane of elements 2, 3, 4, 5 and 6 with their thickness being in the Y direction.

In the Z direction on a surface of the layers 2, 3, 4, 5 and 6, a smaller energy gap semiconductor layer 7 having a width d₀ is provided. Continuing in the Z direction, a region with a larger energy gap labelled element 8, with a thickness d₃ is provided. The exposed surface 11 of layer 8 or any subsequent layers is within current influencing proximity to layer 7.

In the resulting structure, at the intersection of the smaller band gap lower energy level layers 3 and 5 in one crystallographic direction in the multidirectional superlattice that intersect with an even smaller band gap still lower energy level layer 7 of the regions 7 and 8 in a different crystallographic direction, the energy conditions will be such that carriers, both electrons and holes, will be confined in the Y and in the Z directions but will be free only in the X direction. Thus, a one-dimensional quantum pipeline type carrier path is formed at that intersection. An example of two pipelines are shown in Figure 1, the first is labelled 9 at the intersection of layers 5 and 7 and the second is labelled 10 at the intersection of layers 3 and 7.

The availability of the control element surface in current influencing proximity in the multidirectional superlattice provides control.

Referring again to Figure 1, the carriers in the pipeline can be populated or depopulated and motion in the X direction can be controlled by an externally applied signal along the control element surface 11 which is in current influencing proximity.

The structure of Figure 1 may be fabricated of Ga₁₋ₓ₁Alₓ₁As with a thickness of d₁, an Ga₁₋ₓ₂Alₓ₂As with a thickness of d₂ where x₂>x₁ in the Y direction. A group unit in a crystallographic direction of the epitaxial layers 2, 3, 4, 5 and 6, would be cut, polished and etched, with particular attention to providing a growth interface at the XY plane where a layer 7 of GaAs is grown to a thickness of d₀ and thereon a layer 8 of Ga₁₋ₓ₃Alₓ₃As having a thickness d₃ and where x₃ is at least equal to x₂, is grown on the GaAs layer 7. Current influencing proximity of a control element on the surface 11 is affected by the thickness d₃.

The carriers provided in the pipelines 9 and 10 may be achieved by direct doping or by modulation doping. Where direct doping is employed signals applied through surface 11 can enhance as well as deplete the carrier population in the pipeline. In the use of modulation doping, the impurity is located in element 8, but the carrier is in the adjacent pipeline in element 7.

The physical principles involved in the multi-directional superlattice and quantum pipeline carrier path therein are illustrated in connection with the energy diagrams of Figures 2, 3, 4 and 5.

The energy confinement in the quantum carrier path pipes 9 and 10 is illustrated for each individual axis separately, respectively in connection with Figure 2 for the Z axis, Figure 3 for the Y axis and Figure 4 for the X axis.

For purposes of explanation, while the condition for confinement that there be layers with lower energy levels abutting layers on each side with higher energy levels where shown as equal for illustration one skilled in the art in the light of the following discussion will be able to make many substitutions where materials fortuitous for other purposes may be usable so long as higher.

Considering first, Figures 2, 3 and 4.

Along the E or energy scale of Figures 2, 3 and 4, E_{c} corresponds to the conduction band energy level of the lowest energy level material in the system, which in the illustration is the GaAs 7. E_{c}(x₁) represents the energy level of the conduction band of the Ga₁₋ₓ₁Alₓ₁As of layers 3 and 5. E_{c}(x₂,x₃) represents the energy level of the conduction band of the Ga₁₋ₓ₂Alₓ₂As of layers 2, 4 and 6 for x₂ and for the Ga₁₋ₓ₃Alₓ₃As of layer 8 for x₃. Eₒ is the ground state of the entire system. This state is occupied by the electrons. In each of Figures 2 and 3 in the horizontal or respectively the Z and Y directions, the widths of d₀, d₁ and d₂ are shown.

One property of the multidirectional superlattice with the proximate control surface is that at the intersection of lower energy level layers with an even lower energy level layer there will be a location where carriers can accumulate which will then require greater energy to travel in any direction other than in a selected direction. The selected direction for illustration is the X direction.

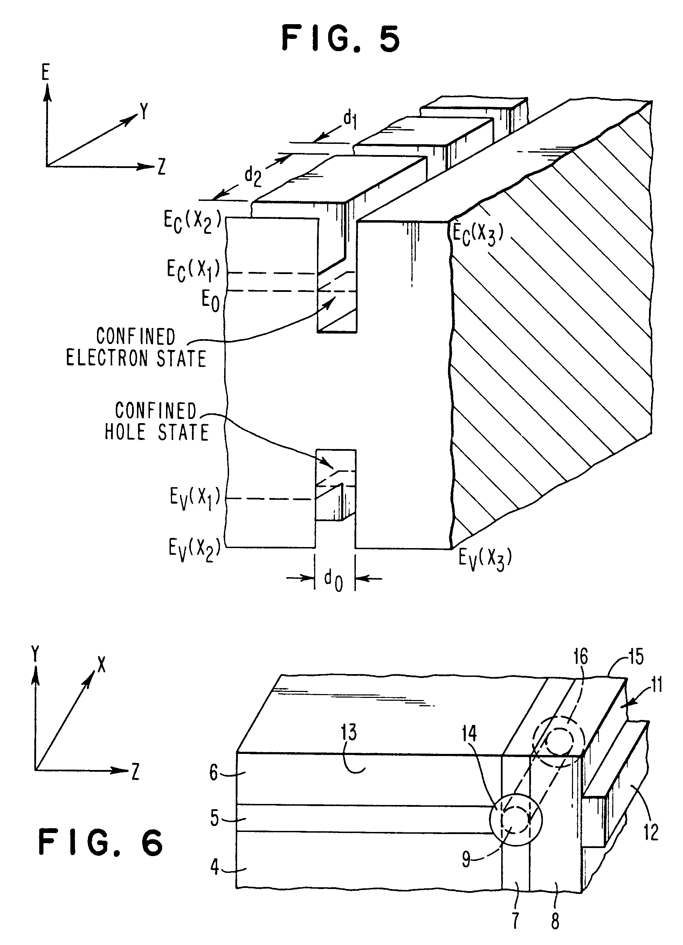

The physical principles involved are further illustrated by the combining of the three energy diagrams of Figures 2, 3 and 4 in their respective axial directions as shown in Figure 5. An orientation diagram is again provided in which in this illustration the energy E is the vertical and the Y and Z planes are the horizontal. The same designations for Eₒ and E_{c} and for X₁, X₂ and X₃ as in Figures 2, 3 and 4 are employed. The valence energy level for the different X values of Al(X₁, X₂ and X₃) is labelled Eᵥ. The energy confining properties of the structure provide a condition in the lowest energy level layer 7 of Figure 1 having the width d₀ illustrated in the energy diagram of Figure 5 where there are symmetrical electron and hole confined states that are linearly, vertically aligned in the d₀ width. This property provides a unique environment where all optical transitions will involve discrete energies with enhanced exciton binding. The advanced optical properties will enhance performance in optical and electro-optical semiconductor structures.

The resulting structure may be considered to be a one-dimensional quantum well structure. It may be viewed in essence as being assembled by converting one side of the potential barrier of an asymmetric quantum well into a periodically indented potential, as shown in Figure 5, between E_{c}(x₂) and E_{c}(x₁) and Eᵥ(x₁ and x₂) across d₂ and d₁. This in turn produces both electron and hole confinement in the one-dimensional channel adjacent to the indented region of the side potential barrier.

To assure a one-dimensional electron system, as coupling between neighbouring pipelines would tend to deviate a system toward two-dimensional, it is desirable to design the structure with relatively large values in differences between x₂ and x₁ and d₂ and d₁.

It will be apparent to one skilled in the art that in both Figures 2, 3 and 4 and in Figure 5, that while for illustration purposes the potentials are drawn square, a space charge effect however small would have to be taken into account in solving the three-dimensional problem for Eₒ as well as all energy schemes.

Referring next to Figure 6, there is illustrated the use of the property of the control surface in the multidirectional superlattice to provide carrier control in the single dimensional quantum pipeline type carrier path, and to provide for the making of connections to the pipeline in the employing of the principles involved in fabricating a device.

On the control surface 11 an example control element conductor 12 is provided to which a signal can be applied with either polarity. The carrier population in the carrier path will be enhanced or depleted according to polarity. Conduction in the pipeline 9 can be controlled where the control element 12 is along or essentially parallel to the pipeline 9. Further, where the element 12 is constructed to cross the pipeline 9 or a series of such pipelines, in other words, the conductor 12 in Figure 6 would then be vertical instead of horizontal as shown, combinational logic type control is achieved. While for clarity of explanation, a single pipeline and control are shown, it will be apparent to one skilled in the art in the light of the principles set forth that extensions and substitutions in number and direction can be fabricated.

Connections to the pipe line can readily be made through an adjacent surface. Through front surface 1 3, a standard "reach through" type high conductivity connection 14 is shown as an example and correspondingly on the back surface 15 an identical contact 16 is made again in the conventional manner to separated parts of the pipeline 9 as illustrated so that transistor action can be achieved via a signal on element 12 serving as a gate. For this type of structure, element 12 could be either parallel with the pipeline 9 or perpendicular to it.

The structure described above would preferably be fabricated by using a GaAs substrate and growing a GaAs buffer thereon, neither shown in the Figures, followed by a series of alternate shown layers 2-6 (Figure 1) of Ga₁₋ₓAlₓAs in the X-Z plane, with thickness in the Y direction. The GaAlAs would have different values of x corresponding with Figure 1 of x₁ = 0.2, x₂ = 0.4 and thicknesses d₂ > d₁ of the order where d₁ would be about 100Å (10 nm) and d₂ about 500Å (50 nm).

The grown structure would be prepared for further growing on the X-Y plane by establishing a growth plane of growth quality surface texture on the crystal of the first series of layers in a crystallographic direction different from the crystallographic direction of that first series. A layer 7 of GaAs having a thickness d₀ of 10-200Å (1-20 nm) with 50Å (5 nm) preferred, would be grown. Following that, there would be grown a layer 8 of GaAlAs having a concentration x₃ of 0.8 and a thickness d₃ of about 500Å (50 nm). All regions would be undoped with the exception of 7 which would be either conventionally doped or modulation doped through 8. The preferred dopant would be Si to provide an electron concentration of about 10¹⁷ atoms/cc or 10¹¹ atoms two-dimensional sheet density.

The superlattice structure would be grown by either molecular beam epitaxy or metal organic chemical vapour deposition as is standard in the art. Since the structure has such narrow regions, it is important not to be reckless with temperatures. For molecular beam epitaxy, it would be well not to exceed 600°C and for metal organic chemical vapour deposition about 800°C.

The connections 14 and 16 are applied by standard ohmic contact techniques. The control members 12 are patterned in the configuration desired, and then formed by depositing Al. Under these circumstances and at the thickness and doping used, the signal applied to the control member or gate 12 influencing conduction between contacts 14 and 16 would be of the order of 1-10 volts. Electron concentrations of 10⁶/cm and mobilities greater than 10⁶/cm² per volt sec are achievable.

In summary, what has been described is a multi-directional superlattice crystal with a control surface and a quantum pipeline type single dimensional carrier path for semiconductor structures that is achieved by providing in the multidimensional superlattice intersecting lower and even lower energy level layers providing a pipeline that has electrons, holes and corresponding electrons and holes.

## Claims

1. A multidirectional monocrystalline semiconductor superlattice structure comprising in combination:
a first series of superlattice layers (2, 3, 4, 5, 6) in a first crystallographic direction comprising at least one group of alternate layers (4, 5, 6) having different energy band gaps and thickness dimensions (d₁, d₂) including a first layer (5) with a first energy band gap which is bounded by second and third layers (4, 6) having energy band gaps and thickness dimensions higher than the first layer (5); thereby to provide a substantially uncoupled lower energy level (E_{c}(x₁)) for charge carriers in the first layer,
at least one second series of superlattice layers (7, 8), each in a crystallographic direction different from the first direction and intersecting the respective layers of the first series, the second series having a fourth layer (7) immediately adjacent the edges of the layers of the first series, the fourth layer being narrower than the second and third layers (4, 6), having an energy band gap lower than the first energy band gap and being bounded by a fifth layer (8) having an energy band gap higher than the first energy band gap; thereby to define a one-dimensional carrier path (9) along the intersections of the first and fourth layers.

2. A structure according to claim 1 comprising, in addition, an exposed control surface (11) for each additional series of layers in current influencing proximity to the fourth layer (7).

3. A structure according to claim 2 wherein said current influencing proximity is established by the thickness (d₃) of the fifth (8) and possible subsequent layers in each additional series.

4. A structure according to any one of the preceding claims wherein the second, first and third layers are, respectively, of GA₁₋ₓ₂A1ₓ₂As, GA₁₋ₓ₁Alₓ₁As and Ga₁₋ₓ₂A1ₓ₂As where x₂>x₁ and wherein the fourth layer is GaAs and the fifth layer is Ga₁₋ₓ₃Alₓ₃As where x₃≧x₂.

5. A structure according to any one of the preceding claims wherein the thickness (d₁) of said first layer (5) is 10 nm.

6. A structure according to any one of the preceding claims wherein said control surface (11) is 50 nm from said carrier path (9).

7. A semiconductor device comprising a structure according to any one of claims 2 to 6 wherein ohmic external electrodes means (14, 16) are located at separated points along the carrier path (9) and control means (12) are positioned on the control surface (11) in current influencing proximity to the carrier path (9) and intermediate said separated points, said control means being operable to alter the carrier population in the carrier path.

8. A process of forming a multidirectional monocrystalline semiconductor superlattice structure comprising in combination the steps of:
fabricating a series of different thickness epitaxial semiconductor superlattice layers (2, 3, 4, 5, 6) in a first crystallographic direction;
establishing at least one growth plane of growth quality surface texture on the crystal of said first series of layers, said plane being in a crystallographic direction different from said first
crystallographic direction; and
growing at least one subsequent series of superlattice layers (7, 8) with controlled thickness on each said growth plane wherein in the first series of layers there is formed at least one group of layers (4, 5, 6) comprising a first layer (5) with a first energy band gap and a first thickness (d₁) which is bounded by second and third layers (4, 6) which are thicker (d₂) than the first layer and have an energy band gap higher than the first energy band gap, thereby to provide a substantially uncoupled lower energy level (E_{c}(x₁)) for charge carriers in the first layer; wherein, in one subsequent series of layers, a fourth layer (7) is formed immediately adjacent the growth crystal of the first series of layers, the fourth layer being narrower (d₀) than the second and third layers and having an energy band gap (E_{c}) lower than the first energy band gap, and wherein the fourth layer (7) is bounded by a fifth layer (8) having a higher energy band gap than the first layer (5) and a thickness (d₃) which is controlled to a dimension enabling a control surface (11) of the fifth layer (8) to be in current influencing proximity to the carrier path; thereby to define a one-dimensional carrier path (9) along the intersections of the first and fourth layers.

9. A process according to claim 8 wherein the first series is made up of layers of GaAlAs with higher concentrations of Al in higher energy band gap layers, and wherein the fourth layer is formed from GaAs and the fifth and possible subsequent layers in the subsequent series is formed from GaAlAs.

10. A process according to claim 9 including deposition of a control electrode (12) on the exposed surface (11) of the subsequent series of layers and the formation of reach through connections (14, 16) to the carrier path (9).

## Patentansprüche

1. Eine mehrdirektionale monokristalline Halbleiter-Übergitterstruktur, die in kombinierter Form folgendes umfaßt:
eine erste Reihe von Übergitterschichten (2, 3, 4, 5, 6) in einer ersten kristallographischen Richtung, die mindestens eine Gruppe von wechselnden Schichten (4, 5, 6) mit unterschiedlichen Energiebandlücken und Dickenabmessungen (d₁, d₂) umfaßt, einschließlich einer ersten Schicht (5) mit einer ersten Energiebandlücke, die durch zweite und dritte Schichten (4, 6) begrenzt ist, die Energiebandlücken und Dickenabmessungen aufweist, die höher sind als die der ersten Schicht (5); dadurch wird ein im wesentlichen ungekoppeltes niedrigeres Energieniveau (E_{c}(x₁)) für Ladungsträger in der ersten Schicht zur Verfügung gestellt;
mindestens eine zweite Reihe von Übergitterschichten (7, 8), jede in einer kristallographischen Richtung, die sich von der ersten Richtung unterscheidet, und die betreffenden Schichten der ersten Reihe schneidet, wobei die zweite Reihe eine vierte Schicht (7) aufweist, unmittelbar angrenzend an die Kanten der Schichten der ersten Reihe, die vierte Schicht schmäler als die zweite und dritte Schicht (4, 6) ist und eine Energiebandlücke aufweist, die niedriger als die erste Energiebandlücke ist, und die durch eine fünfte Schicht (8) begrenzt wird, welche eine Energiebandlücke aufweist, die höher als die erste Energiebandlücke ist; dadurch wird ein eindimensionaler Trägerpfad (9) entlang der Schnittpunkte der ersten und vierten Schicht festgelegt.

2. Eine Struktur nach Anspruch 1, die außerdem eine freiliegende Steuerfläche (11) für jede zusätzliche Reihe von Schichten in strombeeinflussender Nähe zur vierten Schicht (7) umfaßt.

3. Eine Struktur nach Anspruch 2, in der die genannte strombeeinflussende Nähe durch die Dicke (d₃) der fünften (8) und möglicherweise der folgenden Schichten in jeder zusätzlichen Reihe hergestellt wird.

4. Eine Struktur nach einem der vorangehenden Ansprüche, in der die zweite, erste beziehungsweise dritte Schicht aus Ga₁₋ₓ₂Alₓ₂As, Ga₁₋ₓ₁Alₓ₁As und Ga₁₋ₓ₂Alₓ₂As besteht, wobei x₂ > x₁ ist, und in der die vierte Schicht aus GaAs und die fünfte Schicht aus Ga₁₋ₓ₃Alₓ₃As besteht, wobei x₃ ≧ x₂ ist.

5. Eine Struktur nach einem der vorangehenden Ansprüche, in der die Dicke (d₁) der genannten ersten Schicht (5) 10 nm beträgt.

6. Eine Struktur nach einem der vorangehenden Ansprüche, in der die genannte Steuerfläche (11) 50 nm vom genannten Trägerpfad (9) entfernt ist.

7. Ein Halbleiter-Bauelement, das eine Struktur entsprechend einem der Ansprüche 2 bis 6 aufweist, in der ohmsche externe Elektrodenmittel (14, 16) an getrennten Punkten entlang dem Trägerpfad (9) angeordnet sind und Steuermittel (12) auf der Steuerfläche (11) in strombeeinflussender Nähe zum Trägerpfad (9) und zwischen den genannten Punkten angeordnet sind, wobei die genannten Steuermittel so betätigt werden können, daß die Trägerbesetzung in dem Trägerpfad verändert werden kann.

8. Ein Verfahren zur Bildung einer mehrdirektionalen monokristallinen Halbleiter-Übergitterstruktur, die eine Kombination folgender Schritte umfaßt:
Herstellen einer Reihe epitaxialer Halbleiter-Übergitterschichten unterschiedlicher Dicke (2, 3, 4, 5, 6) in einer ersten kristallographischen Richtung;
Einrichten mindestens einer Wachstumsebene mit einer Oberflächenstruktur in Wachstumsgualität auf dem Kristall der genannten ersten Reihe von Schichten, wobei die genannte Ebene in einer kristallographischen Richtung verläuft, die sich von der genannten ersten kristallographischen Richtung unterscheidet; und
Züchten mindestens einer nachfolgenden Reihe von Übergitterschichten (7, 8) mit kontrollierter Dicke auf jeder genannten Wachstumsebene, wobei in der ersten Reihe von Schichten mindestens eine Gruppe von Schichten (4, 5, 6) gebildet wird, die eine erste Schicht (5) mit einer ersten Energiebandlücke und einer ersten Dicke (d₁) umfaßt, die durch zweite und dritte Schichten (4, 6) begrenzt ist, die dicker (d₂) als die erste Schicht sind und eine Energiebandlücke aufweisen, die höher als die erste Energiebandlücke ist, wodurch ein im wesentlichen ungekoppeltes niedrigeres Energieniveau (E_{c}(x₁)) für Ladungsträger in der ersten Schicht zur Verfügung gestellt wird, worin, in einer nachfolgenden Reihe von Schichten, eine vierte Schicht (7) gebildet wird, die unmittelbar an den Wachstumskristall der ersten Reihe von Schichten angrenzt, wobei die vierte Schicht schmäler (d₀) als die zweite und dritte Schicht ist und eine Energiebandlücke (E_{c}) aufweist, die niedriger als die erste Energiebandlücke ist, und in der die vierte Schicht (7) von einer fünften Schicht (8) begrenzt wird, die eine höhere Energiebandlücke als die erste Schicht (5) und eine Dicke (d₃) aufweist, die so gesteuert wird, daß sie ein Maß aufweist, welches eine Steuerfläche (11) der fünften Schicht (8) ermöglicht, die in strombeeinflussender Nähe zu dem Trägerpfad liegt; hierdurch wird ein eindimensionaler Trägerpfad (9) entlang den Schnittstellen der ersten und vierten Schichten festgelegt.

9. Ein Verfahren nach Anspruch 8, in dem die erste Reihe von Schichten aus GaAlAs aufgebaut wird, mit höheren Al-Konzentrationen in Schichten mit höherer Energiebandlücke, und in dem die vierte Schicht aus GaAs und die fünfte und möglicherweise nachfolgende Schichten in der nachfolgenden Reihe aus GaAlAs gebildet werden.

10. Ein Verfahren nach Anspruch 9, das den Niederschlag einer Steuerelektrode (12) auf der freiliegenden Fläche (11) der nachfolgenden Reihe von Schichten umfaßt, sowie die Bildung von "reach through"-Verbindungen (14, 16) zum Trägerpfad (9).

## Revendications

1. Structure semiconductrice monocristalline en superréseau, comprenant en combinaison:
une première série de couches de super-réseau (2, 3, 4,5, 6) dans une première direction cristallographique comprenant au moins un groupe d'autres couches (4, 5, 6) ayant des sauts d'énergie et des dimensions d'épaisseur (d₁, d₂) différents comprenant une première couche (5) avec un premier saut d'énergie qui est limitée par des deuxième et troisième couches (4, 6) ayant des sauts d'énergie et des dimensions d'épaisseur supérieurs à ceux de la première couche (5), et ce, afin de fournir un niveau d'énergie plus faible sensiblement non couplé (E_{c} (x₁)) aux porteurs de charge dans la première couche,
Au moins une deuxième série de couches de super-réseau (7, 8), chacune étant dans une direction cristallographique différente de la première direction et faisant intersection avec les couches respectives de la première série, la deuxième série ayant une quatrième couche (7) immédiatement adjacente aux bords des couches de la première série, la quatrième couche étant plus étroite que les deuxième et troisième couches (4, 6) et ayant un saut d'énergie inférieur au premier saut d'énergie et étant limitée par une cinquième couche (8) ayant un saut d'énergie supérieur au premier saut d'énergie, et ce, afin de définir un trajet de porteurs unidimensionnel (9) le long des intersections des première et quatrième couches.

2. Structure selon la revendication 1 comprenant, en outre, une surface de contrôle exposée (11) pour chaque série supplémentaire de couches dans la proximité d'influence de courant de la quatrième couche (7).

3. Structure selon la revendication 2, dans laquelle ladite proximité d'influence de courant est établie par l'épaisseur (d₃) de la cinquième (8) et éventuellement des couches suivantes dans chaque série supplémentaire.

4. Structure selon l'une quelconque des revendications précédentes, dans laquelle les deuxième, troisième et quatrième couches sont respectivement faites en Ga₁₋ₓ₂Alₓ₂As, Ga₁₋ₓ₁Alₓ₁As et Ga₁₋ₓ₂Alₓ₂As, où x2>x1 et dans laquelle la quatrième couche est GaAs et la cinquième couche est Ga₁₋ₓ₃Alₓ₃As où x3≧x2.

5. Structure selon l'une quelconque des revendications précédentes, dans laquelle l'épaisseur (d₁) de ladite première couche (5) est de 10 nm.

6. Structure selon l'une quelconque des revendications précédentes, dans laquelle ladite surface de contrôle (11) est à 50 nm dudit trajet de porteurs (9).

7. Dispositif semiconducteur ayant une structure selon l'une quelconque des revendications 2 à 6, dans lequel les moyens d'électrodes externes ohmiques (14, 16) sont placés en des points séparés le long du trajet de porteurs (9), et des moyens de contrôle (12) sont positionnés sur la surface de contrôle (11) dans la proximité d'influence de courant du trajet de porteurs (9) et en étant intermédiaires auxdits points séparés, lesdits moyens de contrôle pouvant fonctionner pour altérer la population des porteurs dans le trajet de porteurs.

8. Procédé de fabrication d'une structure semiconductrice monocristalline multidirectionnelle en super-réseau, comprenant en combinaison les étapes de:
fabriquer une série de couches en super-réseau épitaxiques d'épaisseur différente (2, 3, 4, 5, 6) dans une première direction cristallographique;
établir au moins un plan de croissance de texture de surface de qualité de croissance sur le cristal de ladite première série de couches, ledit plan étant dans une direction cristallographique différente de ladite première direction cristallographique; et
soumettre à croissance au moins une autre série de couches de super-réseau (7, 8) avec une épaisseur contrôlée sur chacun desdits plans de croissance, dans laquelle il est formé dans la première série de couches au moins un groupe de couches (4, 5, 6) comprenant une première couche (5) avec un premier saut d'énergie et une première épaisseur (d₁) qui est limitée par des deuxième et troisième couches (4, 6) qui sont plus épaisses (d₂) que la première couche et ont un saut d'énergie supérieur au premier saut d'énergie, et ce, de manière à fournir un niveau d'énergie plus faible sensiblement non couplé (E_{c}(x₁)) aux porteurs de charge dans la première couche, dans laquelle, dans une autre série de couches, il est formé une quatrième couche (7) immédiatement adjacente au cristal de croissance de la première série de couches, la quatrième couche (7) étant plus étroite (d₀) que les deuxième et troisième couches et ayant un saut d'énergie (E_{c}) inférieur au premier saut d'énergie, et dans laquelle la quatrième couche (7) est limitée par une cinquième couche (8) ayant un saut d'énergie plus élevé que la première couche (5) et une épaisseur (d₃) qui est contrôlée pour atteindre une dimension permettant à une surface de contrôle (11) de la cinquième couche (8) d'être dans la proximité d'influence de courant du trajet de porteurs, et ce, afin de définir un trajet de porteurs unidimensionnel (9) le long des intersections des première et quatrième couches.

9. Procédé selon la revendication 8, dans lequel la première série est constituée de couches de GaAlAs avec de plus fortes concentrations de Al dans des couches à saut d'énergie plus élevé, et dans lequel la quatrième couche est faite de GaAs et les cinquième et autres couches possibles de la série suivante sont faites de GaAlAs.

10. Procédé selon la revendication 9, comprenant le dépôt d'une électrode de commande (12) sur la surface exposée (11) de la série suivante de couches, et la formation de connexions de liaison (14, 16) avec le trajet de porteurs (9).
